# EUROPEAN PATENT SPECIFICATION

(11) **EP 3 758 076 B1**
(45) Date of publication and mention of the grant of the patent: **19.04.2023**
(21) Application number: 20190306.9
(22) Date of filing: 23.11.2010
(51) Int. Cl.: H01L 33/38, H01L 33/46

(54) **LIGHT EMITTING DIODE**
LICHTEMITTIERENDE DIODE
DIODE ÉLECTROLUMINESCENTE

(30) Priority: 28.12.2009 KR 20090131693
(43) Date of publication of application: 30.12.2020
(62) Divisional of application: 10192249.0
(73) Proprietor: Seoul Viosys Co., Ltd., Gyeonggi-do 00000 (KR)
(72) Inventor: Yoon, Yeo Jin, 425-851 Gyeonggi-do (KR); Seo, Won Cheol, 425-851 Gyeonggi-do (KR)
(74) Representative: Isarpatent

(56) References cited:
- EP-A2- 1 256 987
- WO-A2-2009/020365
- WO-A2-2009/125953
- TW-A- 200 921 936
- US-A1- 2006 169 994
- US-A1- 2007 145 380
- US-A1- 2008 303 047
- US-A1- 2009 108 250
- US-A1- 2009 114 935

## Description

### BACKGROUND OF THE INVENTION

### FIELD OF THE INVENTION

Exemplary embodiments of the invention relate to light emitting diodes and, more particularly, to light emitting diodes configured to prevent a reduction in light emitting area resulting from formation of an electrode or electrode pad.

### DESCRIPTION OF THE BACKGROUND

Gallium nitride (GaN) based light emitting diodes (LEDs) have been applied and developed for about 10 years. GaN-based LEDs represent a significant change in LED technology and are used in a wide range of applications including natural color LED display devices, LED traffic sign boards, white LEDs, etc. In recent years, a highly efficient white LED is expected to replace fluorescent lamps and, in particular, efficiency of the white LED approaches an efficiency level of typical fluorescent lamps.

The GaN-based light emitting diode is generally formed by growing epitaxial layers on a substrate, for example, a sapphire substrate, and includes an N-type semiconductor layer, a P-type semiconductor layer and an active layer interposed between the N-type semiconductor layer and the P-type semiconductor layer. Further, an N electrode is formed on the N-type semiconductor layer and a P electrode is formed on the P-type semiconductor layer. The light emitting diode is electrically connected to and operated by an external power source through these electrodes. Here, electric current is directed from the P-electrode to the N-electrode through the semiconductor layers.

Generally, since the P-type semiconductor layer has high specific resistance, electric current is not evenly distributed in the P-type semiconductor layer, but is concentrated on a portion of the P-type semiconductor layer having the P-electrode formed thereon, causing a problem of current concentration on an edge of the P-type semiconductor layer. The current concentration leads to a reduction in light emitting area, thereby deteriorating luminous efficacy. To solve such problems, a transparent electrode layer having low specific resistance is formed on the P-type semiconductor layer so as to enhance current distribution. In this structure, when supplied from the P-electrode, the electric current is dispersed by the transparent electrode layer before entering the P-type semiconductor layer, thereby increasing a light emitting area of the LED.

However, since the transparent electrode layer tends to absorb light, the thickness of the transparent electrode layer is limited, thereby providing limited current dispersion. In particular, for a large area LED having an area of about 1 mm² or more for high output, there is a limit in current dispersion through the transparent electrode layer.

Meanwhile, the electric current flows into the N electrode through the semiconductor layers. Accordingly, the electric current concentrates on a portion of the N-type semiconductor layer having the N-electrode formed thereon, that is, the current flowing in the semiconductor layers concentrates near a region of the N-type semiconductor layer on which the N-electrode is formed. Therefore, there is a need for a light emitting diode solving the problem of current concentration within the N-type semiconductor layer.

Typically, various types of electrode structures are used for the light emitting diode to ensure uniform current dispersion.

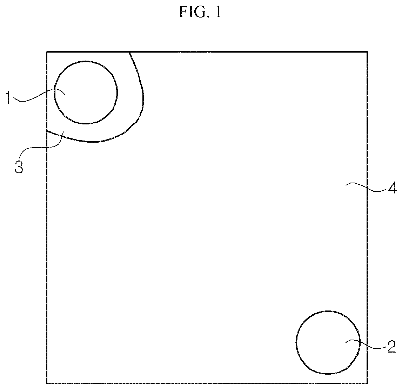

Figure 1 illustrates a light emitting diode having a diagonal electrode structure.

In Figure 1, reference numeral 1 denotes an N electrode, 2 denotes a P electrode, 3 denotes an exposed N-type semiconductor layer, and 4 denotes a transparent electrode layer.

Referring to Figure 1, the diagonal electrode structure is highly effective for a small LED, but causes an increasing concentration of electric current on a central region of the LED as the size of the LED increases, such that only the central region of the LED emits light. In addition, an electrode pattern of a simple facing type structure also suffers from the same problem as the diagonal electrode structure.

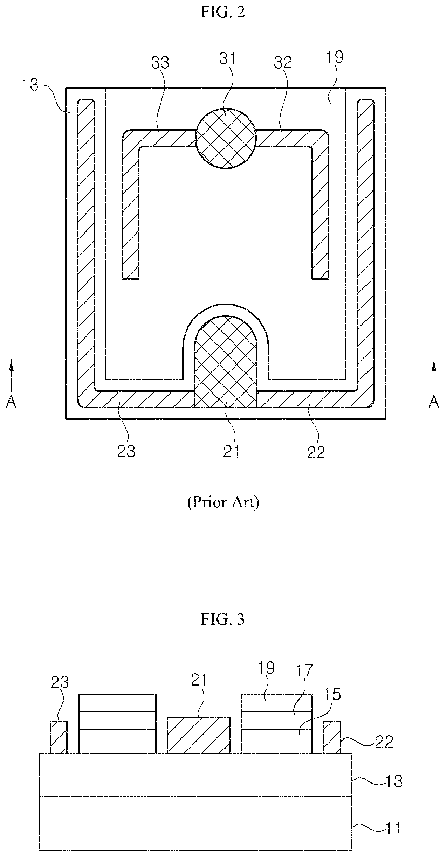

Figure 2 illustrates a light emitting diode having a combined electrode structure of a facing type structure and a symmetrical extension type structure, and Figure 3 is a cross-sectional view taken along line A-A' of Figure 2.

In Figure 2 and Figure 3, reference numeral 11 denotes a substrate, 13 denotes an N-type semiconductor layer, 15 denotes an active layer, 17 denotes a P-type semiconductor layer, 19 denotes a transparent electrode layer, 21 denotes an N electrode, 22 and 23 denote extension parts of the N electrode, 31 denotes a P electrode, and 32 and 33 denote extension parts of the P electrode.

Referring to Figure 2 and Figure 3, the combined electrode structure of the facing type structure and the symmetrical extension type structure is generally used for large sized LEDs. It can be appreciated that the extension parts 22, 23, 32, 33 of the electrodes are formed over a light emitting area of an LED chip with an increased area for ensuring uniform current distribution over the light emitting area.

For the combined type structure, however, since the N-type semiconductor layer 13 is exposed by mesa-etching to form the extension parts 32, 33 of the P electrode 31 and the extension parts 22, 23 of the N electrode 21, the light emitting area is inevitably decreased.

Moreover, in the current state of the art, the number of electrode pads formed on a single chip is more than doubled for current diffusion, and a mesa-etching area for forming electrodes and extension parts of these electrodes is also expanded. Expansion of the mesa-etching area caused by increase in the number of electrode pads results in a decrease of a light emitting area based on the same chip area, thereby deteriorating light emitting efficiency.

Patent document EP 1 256 987 A2 discloses a light emitting diode, comprising: a lower semiconductor layer formed on a substrate; an upper semiconductor layer disposed above the lower semiconductor layer to expose at least a portion of edge regions of the lower semiconductor layer; a first electrode formed on a region of the upper semiconductor layer, with an insulation layer interposed between the first electrode and the region of the upper semiconductor layer; a second electrode formed on another region of the upper semiconductor layer to supply electric current to the upper semiconductor layer; an extension part of the first electrode in direct contact with at least a portion of the exposed lower semiconductor layer; and a DBR layer formed on an opposed side of the substrate, wherein the insulation layer comprises a distributed Bragg reflector structure by alternately stacking two or more insulation layers having different indices of refraction.

### SUMMARY OF THE INVENTION

An exemplary embodiment of the invention provides a light emitting diode configured to prevent a reduction in light emitting area resulting from formation of an electrode or electrode pad.

Additional features of the invention will be set forth in the description which follows, and in part will be apparent from the description, or may be learned by practice of the invention.

Still other aspects, features, and advantages of the present invention are readily apparent from the following detailed description, simply by illustrating a number of particular embodiments and implementations, including the best mode for carrying out the present invention. The present invention can take the form of a variety of different embodiments, and several details can be modified in various obvious respects.

Accordingly, the drawing and description are to be regarded as illustrative in nature, and not as restrictive.

The current invention provides a light emitting diode according to claim 1. Further embodiments are disclosed in the dependent claims.

The insulation layer may be formed over the entire upper surface of the upper semiconductor layer.

The insulation layer includes an insulation layer of a DBR structure under the first electrode.

The light emitting diode includes an insulation layer of a DBR structure under the extension part of the first electrode in a mesa surface region formed to expose the at least a portion of the edge regions of the lower semiconductor layer.

The light emitting diode may further include an insulation layer of a DBR structure around the extension part of the first electrode formed to reach the at least a portion of the exposed lower semiconductor layer.

The insulation layer of the DBR structure is formed by alternately stacking at least two insulation layers having different indices of refraction one above another. Here, the insulation layers positioned at the outermost sides comprise SiO₂.

The light emitting diode may further include an insulation layer of a DBR structure under the second electrode.

The insulation layer of the DBR structure may be formed by alternately stacking at least two insulation layers having different indices of refraction one above another. Here, the insulation layers positioned at the outermost sides may comprise a Si compound. The Si compound may be SiO₂.

The extension part of the first electrode may be formed on an inclined mesa surface extending from the upper semiconductor layer to the lower semiconductor layer.

The light emitting diode may further include an extension part of the second electrode extending from the second electrode on the upper semiconductor layer.

The substrate further includes an insulation layer of a DBR structure formed on an opposed side of the substrate.

The insulation layer of the DBR structure may be formed by alternately stacking at least two insulation layers having different indices of refraction one above another. Here, the insulation layers at the outermost sides may comprise a Si compound. The Si compound may be SiO₂.

The substrate may be a PSS substrate and the insulation layer of the DBR structure may be formed on a PSS region of the substrate.

The insulation layer of the DBR structure may be formed on a bottom surface of the substrate.

The light emitting diode may further include a transparent electrode layer on the upper semiconductor layer.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.
Figure 1 illustrates a light emitting diode having a diagonal electrode structure.
Figure 2 illustrates a light emitting diode having a combined facing type and symmetrical extension type structure.
Figure 3 is a cross-sectional view taken along line A-A' of Figure 2.
Figure 4 is a plan view of a light emitting diode according to one embodiment of the invention.
Figure 5 is a cross-sectional view taken along line A-A of Figure 4.
Figure 6 is a cross-sectional view of a light emitting diode according to another embodiment of the invention.
Figure 7 is a plan view of a light emitting diode according to a further embodiment of the invention.
Figure 8 is a cross-sectional view taken along line B-B' of Figure 7.
Figure 9 is a cross-sectional view taken along line C-C' of Figure 7.
Figure 10 is a cross-sectional view of a light emitting diode according to yet another embodiment of the invention.

### DETAILED DESCRIPTION OF THE INVENTION

The invention is described more fully hereinafter with reference to the accompanying drawings, in which exemplary embodiments of the invention are shown. This invention may, however, be embodied in many different forms and should not be construed as limited to the exemplary embodiments set forth herein. Rather, these exemplary embodiments are provided so that this disclosure is thorough. In the drawings, the size and relative sizes of layers and regions may be exaggerated for clarity. Like reference numerals in the drawings denote like elements.

It will be understood that when an element such as a layer, film, region or substrate is referred to as being "on" another element, it can be directly on the other element or intervening elements may also be present. In contrast, when an element is referred to as being "directly on" another element, there are no intervening elements present.

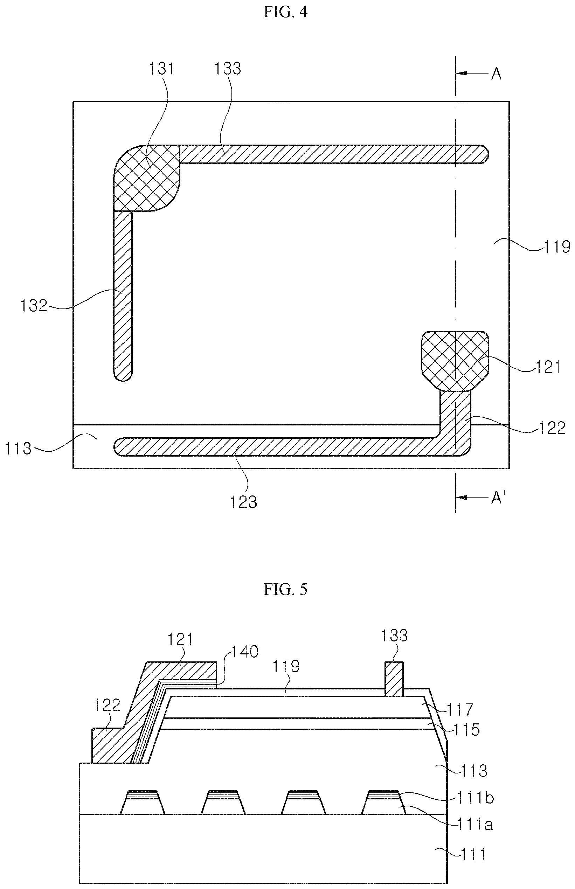

Figure 4 is a plan view of a light emitting diode according to one exemplary embodiment, and Figure 5 is a cross-sectional view taken along line A-A of Figure 4.

Referring to Figure 4 and Figure 5, a first conductive lower semiconductor layer 113 is formed on a substrate 111. The substrate 111 is not limited to a particular material, and may be a sapphire substrate.

A second conductive upper semiconductor layer 117 is formed above the first conductive lower semiconductor layer 113. The upper semiconductor layer 117 is positioned within a region surrounded by edges of the lower semiconductor layer 113 to expose at least a portion of edge regions of the lower semiconductor layer 113. Meanwhile, an active layer 115 is interposed between the lower semiconductor layer 113 and the upper semiconductor layer 117. The active layer 115 is positioned under the upper semiconductor layer 117 while exposing the at least a portion of the edge regions of the lower semiconductor layer 113.

The lower semiconductor layer 113, active layer 115 and upper semiconductor layer 117 may be formed of, but not limited to, a GaN-based compound semiconductor material such as (B, Al, In, Ga)N. The active layer 115 is composed of elements determined to emit light at desired frequencies, for example, UV or blue light. The lower semiconductor layer 113 and the upper semiconductor layer 117 are formed of materials having a greater band gap than the active layer 115.

As shown in the drawings, the lower semiconductor layer 113 and/or the upper semiconductor layer 117 may have a single layer structure or a multilayer structure. Further, the active layer 115 may have a single quantum well structure or a multi-quantum well structure. The light emitting diode may further include a buffer layer (not shown) between the substrate 111 and the lower semiconductor layer 113. The buffer layer is selected to relieve lattice mismatch between the substrate 111 and the lower semiconductor layer 113 formed thereon.

These semiconductor layers 113, 115, 117 may be formed by metal organic chemical vapor deposition (MOCVD) or molecular beam epitaxy (MBE) and may be subjected to mesa-etching to expose regions of the lower semiconductor layer 113 via photolithography and etching.

Here, mesa-etching may be performed to form an inclined mesa surface on the semiconductor layer. The mesa surface may have a degree of inclination in the range of 20-80 degrees, and preferably in the range of 30-60 degrees.

The inclined mesa surface may enhance workability and reliability when forming a second insulation layer 140 of a DBR structure and an inclined extension part 122 of the first electrode described below. In addition, the inclined mesa surface increases a light emitting area.

An insulation layer is formed on the upper semiconductor layer 117. The insulation layer may include a first insulation layer 119 and a second insulation layer 140. The first insulation layer 119 is formed on the entire upper surface of the upper semiconductor layer 117 and the inclined surface which is formed by mesa etching, and may be formed of, for example, SiO₂, Si₃N₄, Nb₂O₅, TiO₂, etc.

The second insulation layer 140 may be formed on a selected region of the upper semiconductor layer 117 where the first electrode 121 is to be formed, and a selected region of the mesa surface where the inclined extension part 122 of the first electrode 121 is to be formed, the mesa surface being formed by the mesa etching.

The second insulation layer 140 may be formed, for example, in a distributed Bragg reflector (DBR) structure by alternately stacking materials, which have a great difference in index of refraction therebetween.

The DBR layer is used to provide high reflectivity to a variety of light emitting devices, which have a light emitting function, a light detection function, a light conversion function, etc. The DBR layer may be formed by alternately stacking two kinds of media having different indices of refraction to reflect light based on the difference between the indices of refraction.

The second insulation layer 140 is formed by alternately stacking two or more insulation layers having different indices of refraction, for example, SiO₂, Si₃N₄, Nb₂O₅, or TiO₂. The second insulation layer 140 may be formed by alternately stacking, for example, multiple layers of SiO₂ and TiO₂ or multiple layers of SiO₂ and Si₃N₄ , followed by etching the stacked insulation layers in a predetermined pattern using photolithography.

Here, the insulation layers are stacked such that insulation layers comprising a Si compound, that is, SiO₂, become the outermost layers. TiO₂ may suffer from deformation when subjected to thermal stress. If an insulation layer of TiO₂ is positioned at the outermost side when forming the second insulation layer 140 by alternately stacking SiO₂ and TiO₂, cracking of the second insulation layer 140 may occur after deposition of the second insulation layer 140. However, when stacking multiple layers of SiO₂ layers and TiO₂ layers by first stacking a SiO₂ layer exhibiting less response to thermal stress at the outermost side and then stacking a TiO₂ layer on the SiO₂ layer, the second insulation layer 240 exhibits thermal stability, thereby preventing cracking of the second insulation layer 140 after deposition thereof. Likewise, it is desirable that the second insulation layer 140 include a SiO₂ insulation layer as the outermost layer, which is finally deposited. This structure may guarantee reliability of the second insulation layer 140. Since the second insulation layer 140 is formed by alternately stacking the insulation layers having different indices of refraction one above another, the second insulation layer 140 may have functions of the DBR. Accordingly, when light emitted from the active layer 117 is directed towards the first electrode 121, the second insulation layer 140 may reflect the light, thereby effectively preventing the light emitted from the active layer 117 from being absorbed or blocked by the first electrode 121.

Further, a DBR layer 111b may be formed on a PSS region 111a of the substrate 111.

In another embodiment, an insulation layer having the DBR structure is also formed under the second electrode 131 excluding a portion contacting the upper semiconductor layer 117, as well as the second insulation layer 140 of the DBR structure formed under the first electrode 121.

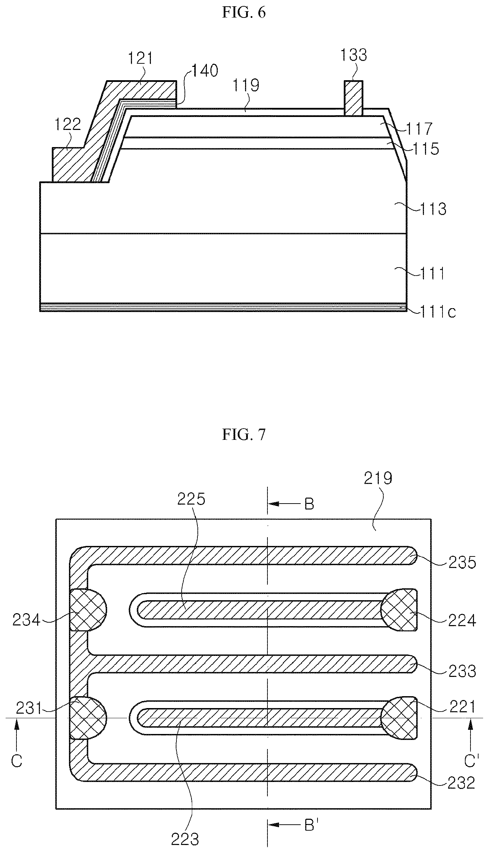

In another embodiment, an insulation layer of the DBR structure is also formed on an exposed portion of the lower semiconductor layer 113 in order to improve emission of light reflected by the second insulation layer 140 under the first electrode 121 or on the mesa surface. In a further embodiment, a DBR layer 111c may be formed on a bottom side of the substrate 111, as shown in Figure 6.

The first electrode 121 is formed in a first region on the upper semiconductor layer 117, with the first and second insulation layers 119, 140 interposed between the first electrode 121 and the upper semiconductor layer 117. An inclined extension part 122 and a lower extension part 123 of the first electrode extend from the first electrode 121 to an edge region of the exposed lower semiconductor layer 113 and are formed along a first side of the substrate. The first electrode 121, the inclined extension part 122 and the lower extension part 123 of the first electrode may be formed of the same material using the same process. For example, if the lower semiconductor layer is an N-type semiconductor layer, the first electrode 121, the inclined extension part 122 and the lower extension part 123 of the first electrode may be formed of Ti/Al using a lift-off process.

Further, the second electrode 131 is formed in a second region on the upper semiconductor layer 117. The second electrode 131 is positioned near a corner between a second side adjacent the first side and a third side adjacent the second side on the upper semiconductor layer 117.

A transparent electrode layer (not shown) may be formed on the upper semiconductor layer 117 before forming the first insulation layer 119. Generally, the transparent electrode layer is formed of indium tin oxide (ITO) or Ni/Au and has transparency. In addition, the transparent electrode layer may lower contact resistance through ohmic contact with the upper semiconductor layer 117. On the other hand, the second electrode 131 has neither transparency nor forms an ohmic contact with the upper semiconductor layer 117. A portion of the second electrode 131 is formed to contact with the upper semiconductor layer 117, and the other portion of the second electrode 131 is formed to contact with the transparent electrode layer. Consequently, the second electrode 131 is configured to form a direct contact with the upper semiconductor layer 117, thereby preventing electric current from flowing under the second electrode 131. Therefore, the light is not generated in the domain of the active layer which is placed under the second electrode 131, but generated in the domain of the active layer which is placed under the transparent electrode layer . With this structure, it is possible to minimize the light emitted from the active layer being absorbed and lost by the second electrode 131.

Meanwhile, a first extension part 132 of the second electrode extends from the second electrode 131 on the upper semiconductor layer 117 to be formed adjacent the second side. A second extension part 133 of the second electrode extends from the second electrode 131 on the upper semiconductor layer 117 to be formed adjacent the third side. The second electrode 131 and the first and second extension parts 132, 133 of the second electrode may be formed of the same material using the same process.

Improvement in light emitting area of the light emitting diode according to the embodiment will be described with reference to comparison of Figure 2 with Figure 4.

In Figure 2 and Figure 4, it can be seen that there is a great difference between the conventional technique and the embodiment in term of reduction in light emitting area resulting from formation of the lower electrode 21 and the first electrode 121, each of which is formed to supply electric current to the lower semiconductor layer. Namely, in the light emitting diode of Figure 2, an area of the light emitting area including the active layer 15 is removed for formation of the lower electrode 21 during mesa etching. On the contrary, in the light emitting diode of Figure 4, the first electrode 121 is formed above the upper semiconductor layer 117, with the first and second insulation layers 119, 140 interposed between the first electrode and the upper semiconductor layer 117, and the active layer 115 remains unetched. Accordingly, the light emitting diode according to the embodiment provides an effective solution of the problem of the related art, in which the light emitting area is reduced due to the formation of the electrode.

In addition, as can be seen from Figure 4, the second insulation layer 140 of the DBR structure formed under the first electrode 121 allows light to be effectively emitted to the outside instead of being absorbed or blocked by the first electrode 121.

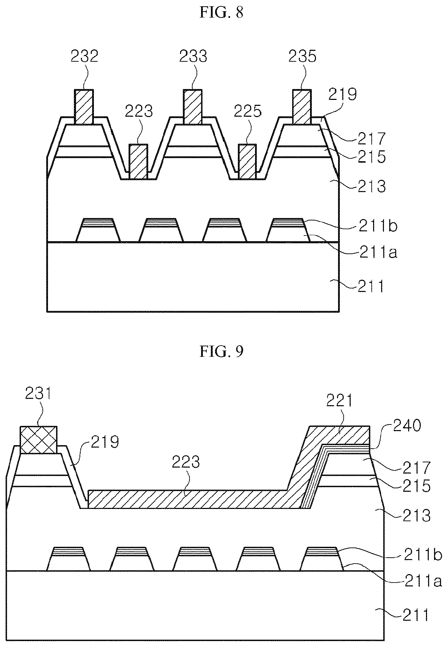

Figure 7 is a plan view of a light emitting diode according to a further exemplary embodiment, Figure 8 is a cross-sectional view taken along line B-B' of Figure 7, and Figure 9 is a cross-sectional view taken along line C-C' of Figure 7.

The embodiment shown in Figures 7 to 9 is different from the embodiment of Figure 4 and Figure 5 in terms of the number, positions and shapes of first and second electrodes, and the shapes of extension parts of the first and second electrodes.

Referring to Figure 7, Figure 8, and Figure 9, first electrodes 221, 224 are formed to face second electrodes 231, 234 on an upper semiconductor layer 217. Each of extension parts 223, 225 of the first electrodes is positioned between extension parts 232, 233 or extension parts 233, 235 of the second electrodes to face each other.

A first conductive lower semiconductor layer 213 is formed on a substrate 211. The substrate 211 is not limited to a particular material, and may be a sapphire substrate.

A second conductive upper semiconductor layer 217 is formed above the first conductive lower semiconductor layer 213. The upper semiconductor layer 217 is positioned within a region surrounded by edges of the lower semiconductor layer 213 to expose at least a portion of edge regions of the lower semiconductor layer 213. Meanwhile, an active layer 215 is interposed between the lower semiconductor layer 213 and the upper semiconductor layer 217. The active layer 215 is positioned under the upper semiconductor layer 217 while exposing the at least a portion of the edge regions of the lower semiconductor layer 213.

The lower semiconductor layer 213, active layer 215 and upper semiconductor layer 217 may be formed of, but not limited to, a GaN-based compound semiconductor material such as (B, Al, In, Ga)N. The active layer 215 is composed of elements determined to emit light at desired frequencies, for example, UV or blue light. The lower semiconductor layer 213 and the upper semiconductor layer 217 are formed of materials having a greater band gap than the active layer 215.

As shown in the drawings, the lower semiconductor layer 213 and/or the upper semiconductor layer 217 may have a single layer structure or a multilayer structure. Further, the active layer 215 may have a single quantum well structure or a multi-quantum well structure. The light emitting diode may further include a buffer layer (not shown) between the substrate 211 and the lower semiconductor layer 213. The buffer layer is selected to relieve lattice mismatch between the substrate 211 and the lower semiconductor layer 213 formed thereon.

These semiconductor layers 213, 215, 217 may be formed by MOCVD or MBE and may be subjected to mesa-etching to expose regions of the lower semiconductor layer 213 via photolithography and etching.

Here, mesa-etching may be performed to form an inclined mesa surface on the semiconductor layer. The mesa surface may have a degree of inclination in the range of 20-80 degrees, and preferably in the range of 30-60 degrees.

The inclined mesa surface may enhance workability and reliability when forming a DBR layer 240 and an inclined extension part 222 of the first electrode described below. In addition, the inclined mesa surface provides an effect of increasing a light emitting area.

An insulation layer is formed on the upper semiconductor layer 217. The insulation layer may include a first insulation layer 219 and a second insulation layer 240. The first insulation layer 219 is formed on entire upper surface of the upper semiconductor layer 217 and the inclined mesa surface which is formed by mesa etching, and may be formed of for example, SiO₂, Si₃N₄, Nb₂O₅, TiO₂, etc.

The second insulation layer 240 may be formed on a selected region of the upper semiconductor layer 217 where the first electrodes 221, 224 is to be formed, and a selected region of the mesa surface where the inclined extension parts 222, 225 of the first electrodes 221, 224 are to be formed, the mesa surface being formed by the mesa etching.

The second insulation layer 240 may be formed, for example, in a DBR structure by alternately stacking materials, which have a great difference in index of refraction therebetween.

The DBR layer is used to provide high reflectivity to a variety of light emitting devices, which have a light emitting function, a light detection function, a light conversion function, etc. The DBR layer may be formed by alternately stacking two kinds of media having different indices of refraction to reflect light based on the difference between the indices of refraction.

The second insulation layer 240 is formed by alternately stacking two or more insulation layers having different indices of refraction, for example, SiO₂, Si₃N₄, Nb₂O₅, or TiO₂. The second insulation layer 240 may be formed by alternately stacking, for example, multiple layers of SiO₂ and TiO₂ or multiple layers of SiO₂ and Si₃N₄, followed by etching a predetermined pattern into the stacked insulation layers using photolithography.

Here, the insulation layers are stacked such that insulation layers comprising a Si compound, that is, SiO₂, become the outermost layers. TiO₂ may suffer from deformation when subjected to thermal stress. If an insulation layer of TiO₂ is positioned at the outermost side when forming the second insulation layer 240 by alternately stacking SiO₂ and TiO₂, cracking of the second insulation layer 240 may occur after deposition of the second insulation layer 240. However, when stacking multiple layers of SiO₂ layers and TiO₂ layers by first stacking a SiO₂ layer exhibiting less response to thermal stress at the outermost side and then stacking a TiO₂ layer on the SiO₂ layer, the second insulation layer 240 exhibits thermal stability, thereby preventing cracking of the second insulation layer 240 after deposition thereof. Likewise, it is desirable that the second insulation layer 240 include a SiO₂ insulation layer as the outermost layer, which is finally deposited. This structure may guarantee reliability of the second insulation layer 240.

Since the second insulation layer 240 is formed by alternately stacking the insulation layers having different indices of refraction one above another, the second insulation layer 240 may have functions of the DBR. Accordingly, when light emitted from the active layer 217 is directed towards the first electrodes 221, 224, the second insulation layer 240 may reflect the light, thereby effectively preventing the light emitted from the active layer 217 from being absorbed or blocked by the first electrodes 221, 224.

Further, a DBR layer 211b may be formed on a PSS region 211a on the substrate 211.

In yet another embodiment, an insulation layer having the DBR structure is also formed under the second electrodes 231, 234 excluding a portion contacting the upper semiconductor layer 217, as well as the second insulation layer 240 of the DBR structure formed under the first electrodes 221, 224.

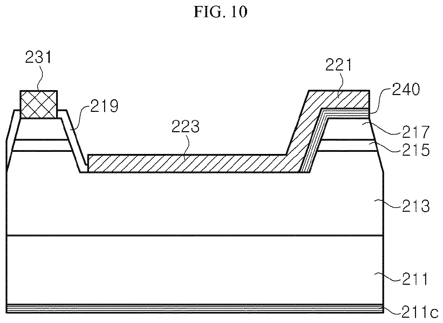

In yet another embodiment, an insulation layer of the DBR structure is also formed on an exposed portion of the lower semiconductor layer 213 in order to improve emission of light reflected by the second insulation layer 240 under the first electrodes 221, 224 or on the mesa surface. In yet another embodiment, a DBR layer 211c may be formed on a bottom side of the substrate 211, as shown in Figure 10.

The first electrodes 221, 224 are formed in a first region on the upper semiconductor layer 217, with the first and second insulation layers 219, 240 interposed between the first electrodes and the upper semiconductor layer. The extension parts 223, 225 of the first electrodes extend from the first electrodes 221, 224 to an edge region of the exposed lower semiconductor layer 213. The first electrodes 221, 224 and the extension parts 223, 225 of the first electrodes may be formed of the same material using the same process. For example, if the lower semiconductor layer is an N-type semiconductor layer, the first electrodes 221, 224 and the extension parts 223, 225 of the first electrodes may be formed of Ti/Al using a lift-off process.

Further, the second electrodes 231, 234 are formed in a second region on the upper semiconductor layer 217. The second electrodes 231, 234 are positioned near an edge of a second side facing a first side on the upper semiconductor layer 217 to be separated a predetermined distance from each other.

A transparent electrode layer (not shown) may be formed on the upper semiconductor layer 217 before forming the first insulation layer 219. Generally, the transparent electrode layer is formed of indium tin oxide (ITO) or Ni/Au and has transparency. In addition, the transparent electrode layer may lower contact resistance through ohmic contact with the upper semiconductor layer 217. On the other hand, the second electrodes 231, 234 have neither transparency nor form an ohmic contact with the upper semiconductor layer 217. A portion of the second electrodes 231, 234 are formed to contact with the upper semiconductor layer 217, and the other portion of the second electrodes 231, 234 are formed to contact with the transparent electrode layer. Consequently, the second electrodes 231, 234 are configured to form a direct contact with the upper semiconductor layer 217, thereby preventing electric current from flowing under the second electrodes 231, 234. Therefore, the light is not generated in the domain of the active layer which is placed under the second electrodes 231, 234, but generated in the domain of the active layer which is placed under the transparent electrode layer . With this structure, it is possible to minimize the light emitted from the active layer being absorbed and lost by the second electrodes 231, 234.

Meanwhile, a first extension part 232 of the second electrode extends from the second electrode 231 on the upper semiconductor layer 217 to be formed adjacent the third side. A second extension part 233 of the second electrode extends along a central line of the substrate from an intermediate portion between the second electrodes 231, 234. A third extension part 233 of the second electrode extends from the second electrode 234 on the upper semiconductor layer 217 to be formed adjacent a fourth side facing the third side. The second electrodes 231, 234 and the first, second and third extension parts 232, 233, 235 of the second electrode may be formed of the same material using the same process.

Improvement in light emitting area of the light emitting diode according to this embodiment will be described through comparison of Figure 2 with Figure 7.

In Figure 2 and Figure 7, it can be seen that there is a great difference between the conventional technique and the embodiment in term of reduction in light emitting area resulting from formation of the lower electrode 21 and the first electrodes 221, 224, each of which is formed to supply electric current to the lower semiconductor layer. Namely, in the light emitting diode of Figure 2, an area of the light emitting area including the active layer 15 is removed for formation of the lower electrode 21 during mesa etching. Thus, when two lower electrodes 21 are formed corresponding to the structure as shown in Figure 7, the light emitting area can be further reduced by mesa etching. On the contrary, in the light emitting diode of Figure 7, the first electrodes 221, 224 are formed above the upper semiconductor layer 217, with the first and second insulation layers 219, 240 interposed between the first electrodes and the upper semiconductor layer 217, and the active layer 215 remains unetched. As such, the light emitting diode according to the embodiment provides an effective solution to the problem of the related art in which the light emitting area is reduced due to the formation of the electrode.

In addition, as can be seen from Figure 7 and Figure 9, the second insulation layer 240 of the DBR structure formed under the first electrodes 221, 224 allows light to be effectively emitted to the outside instead of being absorbed or blocked by the first electrodes 221, 224.

As such, according to one embodiment, an electrode and an extension part for supplying current to a lower semiconductor layer are formed above an upper semiconductor layer with an insulation layer interposed between the electrode and the upper semiconductor layer. Consequently, an area of the semiconductor layer removed by mesa-etching for forming the electrode and the extension part is reduced, thereby preventing a reduction in light emitting area.

Although the invention has been illustrated with reference to some exemplary embodiments in conjunction with the drawings, it will be apparent to those skilled in the art that various modifications and changes can be made in the invention without departing from the scope of the invention, as defined by the claims.
Therefore, it should be understood that the embodiments are provided by way of illustration only and are given to provide complete disclosure of the invention and to provide thorough understanding of the invention to those skilled in the art. Thus, it is intended that the invention covers the modifications and variations of this invention provided they come within the scope of the appended claims.

For example, in the embodiments of the invention, the insulation layer of the DBR structure is formed by alternately stacking two or more insulation layers having different indices of refraction such that the outermost insulation layers are formed of SiO₂, to enhance reliability of the DBR structure. However, it should be understood that this feature may also be applied to all insulation layers set forth herein.

## Claims

1. A light emitting diode, comprising:
a lower semiconductor layer (113, 213) formed on a substrate (111, 211);
an upper semiconductor layer (117, 217) disposed above the lower semiconductor layer (113, 213) to expose at least a portion of edge regions of the lower semiconductor layer (113, 213);
a first electrode (121, 221, 224) formed on a region of the upper semiconductor layer (117, 217), with an insulation layer (119, 140, 219, 240) interposed between the first electrode (121, 221, 224) and the region of the upper semiconductor layer (117, 217);
a second electrode (131, 231, 234) formed on another region of the upper semiconductor layer (117, 217) to supply electric current to the upper semiconductor layer (117, 217);
an extension part (122, 123, 223, 225) of the first electrode (121, 221, 224) in direct contact with at least a portion of the exposed lower semiconductor layer (113, 213); and
a DBR layer (111b, 111c, 211b, 211c) formed below the lower semiconductor layer (113, 213) on an opposed side of the substrate (111, 211),
wherein the insulation layer (119, 140, 219, 240) comprises a distributed Bragg reflector structure by alternately stacking two or more insulation layers having different indices of refraction,
wherein the insulation layer (119, 140, 219, 240) comprises multiple layers including SiO₂
wherein the outermost layer of the insulation layer (119, 140, 219, 240) is an SiO₂ 3102 layer.

2. The light emitting diode of claim 1,
wherein the substrate comprises a patterned sapphire substrate, "PSS", region.

3. The light emitting diode of claim 1,
further comprising a transparent electrode layer formed on the upper semiconductor layer (117, 217) before forming the insulation layer (119, 140, 219, 240).

4. The light emitting diode of claim 3,
wherein the transparent electrode layer is formed of indium tin oxide (ITO).

5. The light emitting diode of claim 1,
wherein the extension part (122, 123, 223, 225) comprises an inclined extension part (122) and a lower extension part (123).

6. The light emitting diode of claim 5,
wherein the lower extension part is formed along a first side of the substrate (111, 211).

7. The light emitting diode of claim 5,
wherein the inclined extension part (122) and the lower extension part (123) are formed of the same material using the same process.

8. The light emitting diode of claim 1,
wherein the second electrode comprises a first extension part (132) or a second extension part (133).

9. The light emitting diode of claim 8,
wherein the first extension part (132) is formed adjacent a second side of the substrate (111, 211).

10. The light emitting diode of claim 9,
wherein the first extension part (132) is formed of the same material using the same process.

11. The light emitting diode of claim 8,
wherein the second extension part (133) is formed adjacent a third side of the substrate (111, 211).

12. The light emitting diode of claim 11,
wherein the second extension part (133) is formed of the same material using the same process.

13. The light emitting diode of claim 1,
wherein the second insulation layer (240) prevents the light emitted from the active layer (217) from being absorbed or blocked by the first electrodes (221, 224).

## Patentansprüche

1. Lichtemittierende Diode, umfassend:
eine untere Halbleiterschicht (113, 213), die auf einem Substrat (111, 211) gebildet ist;
eine obere Halbleiterschicht (117, 217), die so über der unteren Halbleiterschicht (113, 213) angeordnet ist, dass mindestens ein Teil der Randregionen der unteren Halbleiterschicht (113, 213) frei liegt;
eine erste Elektrode (121, 221, 224), die auf einer Region der oberen Halbleiterschicht (117, 217) gebildet ist, wobei eine Isolationsschicht (119, 140, 219, 240) zwischen der ersten Elektrode (121, 221, 224) und der Region der oberen Halbleiterschicht (117, 217) angeordnet ist;
eine zweite Elektrode (131, 231, 234), die auf einer anderen Region der oberen Halbleiterschicht (117, 217) gebildet ist, um der oberen Halbleiterschicht (117, 217) elektrischen Strom zuzuführen;
einen Verlängerungsteil (122, 123, 223, 225) der ersten Elektrode (121, 221, 224) in direktem Kontakt mit mindestens einem Abschnitt der freigelegten unteren Halbleiterschicht (113, 213); und
eine DBR-Schicht (111b, 111c, 211b, 211c), die unter der unteren Halbleiterschicht (113, 213) auf einer gegenüberliegenden Seite des Substrats (111, 211) gebildet ist,
wobei die Isolationsschicht (119, 140, 219, 240) eine verteilte Bragg-Reflektorstruktur durch abwechselndes Stapeln von zwei oder mehr Isolationsschichten, die unterschiedliche Brechungsindizes aufweisen, umfasst,
wobei die Isolationsschicht (119, 140, 219, 240) mehrere Schichten umfasst, die SiO₂ umfassen,
wobei die äußerste Schicht der Isolationsschicht (119, 140, 219, 240) eine SiO₂-Schicht ist.

2. Lichtemittierende Diode nach Anspruch 1,
wobei das Substrat eine strukturierte Saphirsubstrat(Patterned Sapphire Substrate, PSS)-Region umfasst.

3. Lichtemittierende Diode nach Anspruch 1,
umfassend des Weiteren eine transparente Elektrodenschicht, die auf der oberen Halbleiterschicht (117, 217) vor dem Bilden der Isolationsschicht (119, 140, 219, 240) gebildet wird.

4. Lichtemittierende Diode nach Anspruch 3,
wobei die transparente Elektrodenschicht aus Indium-ZinnOxid (ITO) gebildet ist.

5. Lichtemittierende Diode nach Anspruch 1,
wobei der Verlängerungsteil (122, 123, 223, 225) einen geneigten Verlängerungsteil (122) und einen unteren Verlängerungsteil (123) umfasst.

6. Lichtemittierende Diode nach Anspruch 5,
wobei der untere Verlängerungsteil entlang einer ersten Seite des Substrats (111, 211) gebildet ist.

7. Lichtemittierende Diode nach Anspruch 5,
wobei der geneigte Verlängerungsteil (122) und der untere Verlängerungsteil (123) aus dem gleichen Material unter Verwendung desselben Prozesses hergestellt sind.

8. Lichtemittierende Diode nach Anspruch 1,
wobei die zweite Elektrode einen ersten Verlängerungsteil (132) oder einen zweiten Verlängerungsteil (133) umfasst.

9. Lichtemittierende Diode nach Anspruch 8,
wobei der erste Verlängerungsteil (132) neben einer zweiten Seite des Substrats (111, 211) gebildet ist.

10. Lichtemittierende Diode nach Anspruch 9,
wobei der erste Verlängerungsteil (132) aus dem gleichen Material unter Verwendung desselben Prozesses hergestellt ist.

11. Lichtemittierende Diode nach Anspruch 8,
wobei der zweite Verlängerungsteil (133) neben einer dritten Seite des Substrats (111, 211) gebildet ist.

12. Lichtemittierende Diode nach Anspruch 11,
wobei der zweite Verlängerungsteil (133) aus dem gleichen Material unter Verwendung desselben Prozesses hergestellt ist.

13. Lichtemittierende Diode nach Anspruch 1,
wobei die zweite Isolationsschicht (240) verhindert, dass das von der aktiven Schicht (217) ausgesendete Licht durch die ersten Elektroden (221, 224) absorbiert oder blockiert wird.

## Revendications

1. Diode électroluminescente, comprenant :
une couche semi-conductrice inférieure (113, 213) formée sur un substrat (111, 211) ;
une couche semi-conductrice supérieure (117, 217) disposée au-dessus de la couche semi-conductrice inférieure (113, 213) pour exposer au moins une partie de régions de bord de la couche semi-conductrice inférieure (113, 213) ;
une première électrode (121, 221, 224) formée sur une région de la couche semi-conductrice supérieure (117, 217), avec une couche d'isolation (119, 140, 219, 240) interposée entre la première électrode (121, 221, 224) et la région de la couche semi-conductrice supérieure (117, 217) ;
une seconde électrode (131, 231, 234) formée sur une autre région de la couche semi-conductrice supérieure (117, 217) pour fournir un courant électrique à la couche semi-conductrice supérieure (117, 217) ; et
une partie d'extension (122, 123, 223, 225) de la première électrode (121, 221, 224) en contact direct avec au moins une partie de la couche semi-conductrice inférieure exposée (113, 213), et
une couche DBR (111b, 111c, 211b, 211c) formée sous la couche semi-conductrice inférieure (113, 213) sur un côté opposé du substrat (111, 211),
dans laquelle la couche d'isolation (119, 140, 219, 240) comprend une structure de réflecteur de Bragg réparti en empilant alternativement deux couches d'isolation ou plus ayant différents indices de réfraction,
dans laquelle la couche d'isolation (119, 140, 219, 240) comprend plusieurs couches incluant du SiO₂,
dans laquelle la couche la plus externe de la couche d'isolation (119, 140, 219, 240) est une couche de SiO₂.

2. Diode électroluminescente selon la revendication 1,
dans laquelle le substrat comprend une région de substrat saphir à motifs (Patterned Sapphire Substrate, PSS).

3. Diode électroluminescente selon la revendication 1,
comprenant en outre une couche d'électrode transparente formée sur la couche semi-conductrice supérieure (117, 217) avant de former la couche d'isolation (119, 140, 219, 240).

4. Diode électroluminescente selon la revendication 3,
dans laquelle la couche d'électrode transparente est formée d'oxyde d'indium et d'étain (ITO).

5. Diode électroluminescente selon la revendication 1,
dans laquelle la partie d'extension (122, 123, 223, 225) comprend une partie d'extension inclinée (122) et une partie d'extension inférieure (123).

6. Diode électroluminescente selon la revendication 5,
dans laquelle la partie d'extension inférieure est formée le long d'un premier côté du substrat (111, 211).

7. Diode électroluminescente selon la revendication 5,
dans laquelle la partie d'extension inclinée (122) et la partie d'extension inférieure (123) sont formées du même matériau en utilisant le même procédé.

8. Diode électroluminescente selon la revendication 1,
dans laquelle la seconde électrode comprend une première partie d'extension (132) ou une seconde partie d'extension (133) .

9. Diode électroluminescente selon la revendication 8,
dans laquelle la première partie d'extension (132) est formée de manière adjacente à un deuxième côté du substrat (111, 211).

10. Diode électroluminescente selon la revendication 9,
dans laquelle la première partie d'extension (132) est formée du même matériau en utilisant le même procédé.

11. Diode électroluminescente selon la revendication 8,
dans laquelle la seconde partie d'extension (133) est formée de manière adjacente à un troisième côté du substrat (111, 211).

12. Diode électroluminescente selon la revendication 11,
dans laquelle la seconde partie d'extension (133) est formée du même matériau en utilisant le même procédé.

13. Diode électroluminescente selon la revendication 1,
dans laquelle la seconde couche d'isolation (240) empêche la lumière émise par la couche active (217) d'être absorbée ou bloquée par les premières électrodes (221, 224).
